# EUROPEAN PATENT APPLICATION

(11) **EP 1 840 952 A1**
(43) Date of publication of application: **03.10.2007**
(21) Application number: 07075207.6
(22) Date of filing: 19.03.2007
(51) Int. Cl.: H01L 21/56, H01L 23/31, H05K 3/30, H01L 21/60

(54) **Devices with microjetted polymer standoffs**

(30) Priority: 29.03.2006 US 392019
(71) Applicant: Delphi Technologies, Inc., Troy, Michigan 48007 (US)
(72) Inventor: Workman, Derek B., Noblesville, IN 46062 (US)
(74) Representative: Denton, Michael John

(57) **Abstract**

An electronic package having a controlled standoff height between a surface mount electronic device and a substrate includes a plurality of polymeric standoffs adhered to at least one of the underside of the surface mount electronic device or an upper surface of the substrate. The polymeric standoffs prevent collapse of the surface mount electronic device during overmolding or encapsulation of the surface mount electronic device.

## Description

### Technical Field

This invention pertains to electronic semiconductor packages and more particularly to electronic semiconductor packages having standoffs between a substrate and an electronic device mounted on the substrate.

### Background of the Invention

Electronic semiconductor packages are typically comprised of a substrate, such as a printed circuit board, and electronic components or chips that are mounted on the substrate and electrically connected to conductors on the substrate. In order to achieve smaller electronic semiconductor packages, so-called "surface mount" or lead-less electronic components are often preferred. These surface mount electronic components are characterized by the absence of electrical lead wires. Instead, electrical connections between the surface component and the substrate are achieved by a soldered joint located between a terminal on the component and a mounting pad on the substrate and in direct contact with the terminal and mounting pad. Examples of surface mount electronic components include flip chips, ball grid arrays, chip-scale packages, diodes, inductors, capacitors, resistors, and varisters.

It is generally desirable to maintain a uniform spacing or gap between a surface mount device and the substrate to facilitate removal of flux residue and cleaning, and to improve component durability and longevity during thermal cycling of the device. Various standoffs or spacers have been employed to maintain a uniform space or gap between the bottom of a surface mount electronic component and the upper surface of a substrate on which the electronic component is mounted.

A flexible, stainless steel spring spacer has been retained between the underside of a surface mount electronic component and the upper surface of a printed circuit board on which the component is mounted in order to reduce pressure on solder joints when a heat sink is mechanically clamped to the electronic package.

Attempts to maintain an appropriate gap between a surface mount component and a substrate on which the electronic component is mounted have included the use of particulate conductive stand-off members distributed in a solder joint. The stand-off members are comprised of metal alloy having a higher melting temperature than the solder.

It is often desirable to overmold or encapsulate electronic components on an electronic semiconductor package to protect the component from damage. However, overmolding conventional surface mount components, such as flip chips or the like, can lead to device collapse due to the extreme pressure that is placed on the component during the molding operation. Conventional stand-off members located within the soldered joint could have a negative impact on the reliability of the solder joint. Furthermore, this method only provides support at the bump locations. A perimeter-bumped device would not have any support near the middle of the device. Accordingly, there is a need for improved methods and devices in which an appropriate gap is maintained between a surface mount component and a substrate on which the component is mounted during overmolding or encapsulation of the component.

### Summary of the Invention

In one aspect, the invention provides an electronic package comprising a substrate having electrically conductive pathways and at least one conductive mounting pad, a surface mount electronic device having at least one terminal, and a plurality of polymeric standoffs adhered to at least one of the underside of the surface mount electronic device or an upper surface of the substrate to maintain a desired gap between the underside of the surface mount electronic device and the upper surface of the substrate. At least one solder joint electrically and mechanically connects the terminal of the surface mount device to the mounting pad of the substrate. The polymeric standoffs are preferably configured and arranged between the underside of the surface mount electronic device and the substrate to prevent collapse of the electronic device during an overmolding operation.

In accordance with another aspect of the invention, a process for making an electronic package having a controlled height standoff distance between a surface mount device and a circuit board is provided. The method includes steps of providing a substrate having electrically conductive pathways and at least one conductive mounting pad, providing a surface mount electronic device having at least one terminal, depositing a plurality of polymeric standoffs on, and adhering the plurality of polymeric standoffs to, at least one of the underside of the surface mount electronic device or an upper surface of the substrate, and forming a solder joint to connect the terminal of the surface mount device to the mounting pad of the substrate. The polymeric standoffs are preferably configured and arranged on the underside of the surface mount electronic device or the upper surface of the substrate to maintain a desired gap between the underside of the surface mount electronic device and the upper surface of the substrate, and to prevent collapse of the surface mount electronic device during overmolding or encapsulation of the surface mount electronic device. Furthermore, fine-pitched devices would be supported during reflow and this would reduce the risk of shorts developing between adjacent bumps.

In accordance with a preferred embodiment, the polymeric standoffs are deposited on either the underside of the surface mount electronic device or the upper surface of the substrate using a polymer microjetting technique. This technique allows highly accurate drop placement and volume control, enabling the deposition of a well-defined array of polymeric standoffs that can be applied in substantially any desired pattern.

These and other features, advantages and objects of the present invention will be further understood and appreciated by those skilled in the art by reference to the following specification, claims and appended drawings.

### Brief Description of the Drawings

FIG. 1 is a schematic cross section of an electronic package according to the invention having an overmolding that provides a seal between the perimeter of a surface mount electronic device and a substrate.
FIG. 2 is a schematic cross section of an electronic package according to the invention having an underfill disposed between surface mount electronic device and a substrate.
FIG. 3 is a schematic cross section of an electronic package according to the invention having an encapsulant that together with the substrate forms an enclosure around the surface mount electronic device.

### Description of the Preferred Embodiments

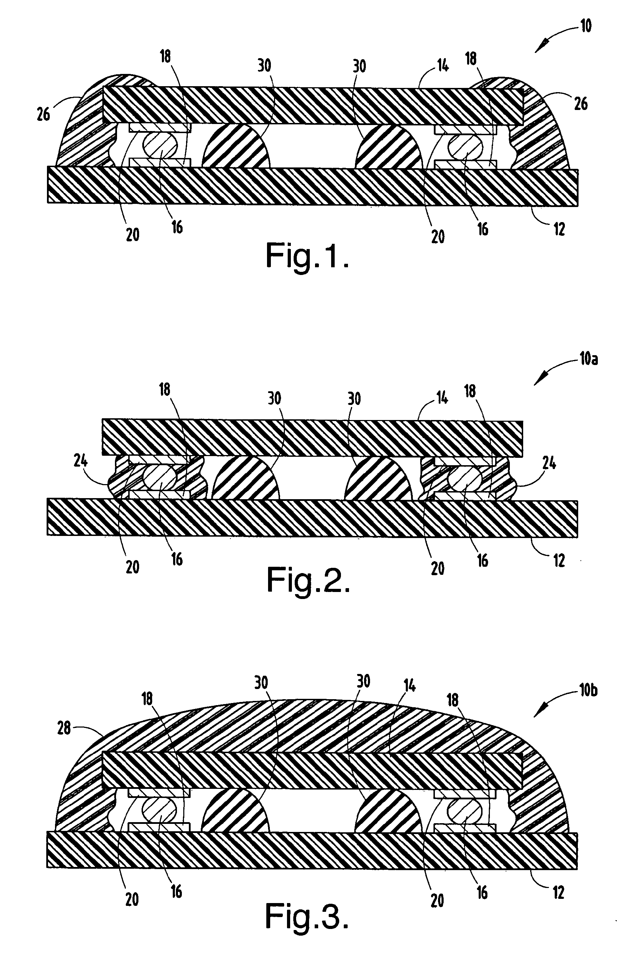

Referring to FIG. 1, an electronic package 10 comprises a substrate 12 having printed or otherwise disposed thereon electrically conductive pathways or traces that together with one or more electronic components mounted on the substrate define an electronic component package. A surface mount electronic device 14 is connected to the circuit board 12 by a solder joint 16. While the illustrated embodiment includes only a single surface mount electronic device 14, it should be appreciated that electronic package 10 may include any number of surface mount electronic devices 14 connected to substrate 12.

Substrate 12 may include a printed circuit board having a dielectric substrate and electrically conductive circuitry, such as printed circuit traces as should be evident to those skilled in the art. Substrate 12 may include electrical circuitry fabricated on both the upper and lower surfaces thereof, as well as electrical circuitry located in intermediate layers of the substrate. Substrate 12 may include an organic-based material, such as an organic resin reinforced by fiber, or inorganic material, such as a ceramic substrate or low-temperature, co-fired ceramic LTCC. Examples of circuit board materials include FR4, alumina, metal plated plastic, flex on aluminium, porcelainized steel and other suitable materials.

Formed on an upper surface of substrate 12 is a mounting pad 18, which is electrically connected to the conductive circuitry, and which is used to mechanically and electrically connect a terminal 20 of surface mount electronic device 14 via a solder joint 16. A solder resist layer (not shown) may be printed on an upper surface of each of the mounting pads 18 to define a solder window boundary that contains a volume of reflowed solder. Alternatively, the pads could be laser defined. During a solder reflow process, a reflowed solder ball is reshaped on an upper surface of a corresponding mounting pad 18.

Surface mount electronic device 14 is mechanically connected and electrically coupled to substrate 12. In the illustrated embodiment, surface mount electronic device 14 includes a plurality of solder ball joints 16 attached on a bottom surface near a perimeter of surface mount device 14. Solder ball joints 16 may be preformed spherical balls attached to contact terminals 20 of surface mount electronic device 14. Solder ball joints 16 may be attached to contact terminals 20 as a solder paste prior to connection on substrate 12 or could be applied by solder jet. During assembly, each solder joint 16 is aligned and is brought into contact with an electrically conductive mounting pad 18 on the top surface of substrate 12. In the illustrated embodiment, surface mount electronic device 14 is a chip, such as a flip chip, having an array of solder balls 16 mechanically and electrically coupled to contact terminals 20 on the bottom side of surface mount electronic device 14.

Surface mount electronic device 14 can be any of a number of different types of electronic devices including semiconductor chips, such as flip chips, ball grid arrays, chip-scale packages, and other electronic devices, such as diodes, inductors, capacitors, resistors, varisters, as well as other electrical connecting devices that are mechanically mountable on a surface of substrate 12.

In the illustrated embodiment, surface mount electronic device is a lead-less chip device having terminals 20 for providing mechanical support connections and electrical signal connections to electrical circuitry on surface mount electronic device 14. Contact terminals 20 may each include a separate layer of electrically conductive material or may include a conductive surface of the electronic component. Each of contact terminals 20 are mechanically and electrically coupled to substrate 12 by solder joints 16.

Electronic package 10 may include an underfill material 24 (FIG. 2) disposed between surface mount electronic device 14 and substrate 12, an overmold material 26 (FIG. 1) which provides a seal between substrate 12 and the perimeter of surface mount electronic device 14, or an encapsulant material 28 (FIG. 3), which together with the substrate provides a protective enclosure for surface mount electronic device 14. Underfill material 24 serves to stabilize surface mount device 14 by at least partially filling the space between surface mount device 14 and substrate 12. Underfill material 24 may also serve to adhere surface mount electronic device 14 to substrate 12 and/or serve as a solder flux to enhance wetting of the solder. Underfill 24, overmold 26 and encapsulant 28 also serve to protect surface mount electronic component from damage, such as during handling.

Underfill material 24 may include a no-flow underfill such as Hysol FF2200, an adhesive such as Chipbonder 3621, a solder flux such as no-clean RMA flux, etc. Either underfill 24, overmold 26, or encapsulant 28 may fill the entire volume between a surface mount electronic device 14 and substrate 12, or only a portion of the volume between surface mount electronic device 14 and substrate 12. Underfill material 24, overmolding material 26 and encapsulating material 28 may also generally comprise a variety of different polymeric materials, such as epoxy resin materials or thermoplastic materials, such as polycarbonate.

Electronic package 10 includes a plurality of polymeric standoffs 30. The term "polymeric" is meant to encompass thermoplastic polymers, thermoset polymers, as well as composite materials having a thermoplastic or thermoset matrix, such as polymer materials containing a property modifying filler. In accordance with the preferred aspects of this invention, polymeric standoffs 30 are precisely positioned in a predetermined pattern using a high precision printing or deposition technique. A preferred technique utilizes microjet printing of a polymeric material, such as an epoxy resin, to form precisely defined structures on the underside of a surface mount electronic device 14 and/or on the upper surface of a substrate 12, which define polymeric standoffs 30. Polymer microjet printing techniques are based on inkjet printing processes which utilize a print head that accurately dispenses picoliter volumes of polymeric formulations at high operating temperatures up to 300°C. Suitable techniques and equipment that may be utilized for precisely forming polymeric standoffs 30 in accordance with this invention are known in the art and described in the literature. See for example "Microjet Printing of Solder and Polymers for Multi-Chip Modules and Chip-Scale Packages," by Donald J. Hayes, David B. Wallace and W. Royall Cox, MicroFab Technologies, Inc., IMAPS 1999.

Standoffs 30 in the illustrated embodiments are deposited on substrate 12. However, as an equivalent alternative, standoffs 30 may be deposited on device 14, or on both device 14 and substrate 12.

In addition to thermosets, a low-viscosity, cyclic thermoplastic precursor could be employed, such as those that are available from Cyclics.

Use of polymeric standoffs 30 in accordance with the principles of this invention provide structural support for surface mount electronic devices 14 mounted on substrate 12 and prevent or reduce excessive strain or collapse of device 14 during solder reflow and/or during overmolding, underfilling or encapsulation. Unlike no-flow and form-in-place pedestals, additional surface mount technology steps are not required when using polymeric standoffs 30 in accordance with this invention. Further, because of the small size and precisely defined structure of polymeric standoffs 30, UV curing or solidification of the polymeric standoffs by heating after deposition on substrate 12 and/or electronic device 14 occurs rapidly, and should not adversely affect production time.

During assembly, surface mount electronic device 14 is brought into contact with substrate 12, such that solder balls 16 contact mounting pads 18. Once solder balls 16 have been properly registered with mounting pads 18, solder joints 16 are formed. The solder joints may be formed by applying an elevated temperature (heat) to the electronic package 10 to cause the solder bumps to reflow on mounting pads 18. During the reflow process, the polymeric standoffs 30 maintain a separation distance between surface mount device 14 and substrate 12. The heated solder balls 16 are reflowed and change shape and are subsequently cooled to solidify and form an electrical and mechanical connection between terminals 20 and mounting pads 14.

It should be appreciated that, in addition to preventing collapse of surface mount electronic device 14 during overmolding or encapsulation, polymeric standoffs 30 achieve a controlled height elevated standoff separation distance between surface mount device 14 and substrate 12. The controlled standoff height may result in a narrow width solder joint 16, which advantageously provides enhanced vibration properties, while preventing short circuiting with adjacent solder joints 16.

Solder joints 16 may be formed of any of a number of known solder materials. According to one exemplary embodiment, solder joints 16 may be comprised of a tin-lead eutectic solder or a tin-lead-copper solder having a reflow temperature of about 220°C or a Pb-free alloy (reflow temperature approximately 240 to 260°C).

Electronic package 10 may be completed by overmolding, encapsulating and/or underfilling operations, which are well-known in the art. Suitable underfilling techniques include underfilling by capillary action between the surface mount electronic device and the substrate, underfilling by compression flow, or "noflow" underfilling.

It will be understood by those who practice the invention and those skilled in the art, that various modifications and improvements may be made to the invention without departing from the spirit of the disclosed concept. The scope of protection afforded is to be determined by the claims and by the breadth of interpretation allowed by law.

## Claims

1. An electronic package comprising:
a substrate having electrically conductive pathways and at least one conductive mounting pad;
a surface mount electronic device having at least one terminal;
a plurality of polymeric standoffs on at least one of an underside of the surface mount electronic device or an upper surface of the substrate, the standoffs maintaining a desired gap between the underside of the surface mount electronic device and the upper surface of the substrate; and
at least one solder joint connecting the terminal of the surface mount device to the mounting pad of the substrate.

2. The electronic package of claim 1, further comprising a polymer overmolding that forms a seal between a perimeter of the surface mount electronic device and the substrate.

3. The electronic package of claim 1, further comprising a polymer encapsulant that together with the substrate form an enclosure around the surface mount electronic device.

4. The electronic package of claim 1, further comprising a polymer underfill disposed between the underside of the surface mount electronic device and the upper surface of the substrate.

5. The electronic package of claim 1, wherein the polymeric standoffs are comprised of a thermoset resin.

6. The electronic package of claim 1, wherein the polymeric standoffs are comprised of an epoxy resin.

7. The electronic package of claim 1, wherein the polymeric standoffs are comprised of a thermoplastic resin.

8. A process for making an electronic package comprising:
providing a substrate having electrically conductive pathways and at least one conductive mounting pad;
providing a surface mount electronic device having at least one terminal;
depositing at a plurality of discrete locations on at least one of an underside of the surface mount electronic device or an upper surface of the substrate a solidifiable polymeric material;
allowing the deposited material to solidify to form a plurality of polymeric standoffs adhered to at least one of the underside of the surface mount electronic device or the upper surface of the substrate;
arranging the terminal of the surface mount electronic device in registry with the mounting pad of the substrate, with a solder ball disposed between the terminal and the mounting pad; and
forming a solder joint to electrically and mechanically connect the terminal of the surface mount electronic device to the mounting pad on the substrate.

9. The process of claim 8, further comprising overmolding the surface mount electronic device to form a seal between a perimeter of the surface mount electronic device and the substrate.

10. The process of claim 8, further comprising encapsulating the surface mount electronic device to enclose the device between an encapsulating material and the substrate.

11. The process of claim 8, further comprising underfilling a polymeric material by capillary action between the surface mount electronic device and the substrate.

12. The process of claim 8, further comprising underfilling a polymeric material by compression flow or "noflow" underfill between the surface mount electronic device and the substrate.

13. The process of claim 8, wherein the polymeric standoffs are comprised of a thermoset resin.

14. The process of claim 8, wherein the polymeric standoffs are comprised of an epoxy resin.

15. The process of claim 8, wherein the plurality of polymeric standoffs are formed by high temperature microjet printing.

16. The process of claim 8, wherein the polymeric standoffs are comprised of a thermoplastic resin.
